# EUROPEAN PATENT APPLICATION

(11) **EP 4 340 141 A1**
(43) Date of publication of application: **20.03.2024**
(21) Application number: 22306354.6
(22) Date of filing: 15.09.2022
(51) Int. Cl.: H01S 5/12, H01S 5/026, H01S 5/40

(54) **DISTRIBUTED FEEDBACK LASERS AND METHODS FOR FABRICATING SUCH LASERS**

(71) Applicant: Almae Technologies, 91460 Marcoussis (FR)
(72) Inventor: Debrégeas, Hélène, Boullay-les-Troux (FR); Belahsene, Sofiane, Rosny-sous-bois (FR); Dubrovina, Natalia, Massy (FR)
(74) Representative: Osha BWB

(57) **Abstract**

The present disclosure relates to a single-mode distributed feedback laser for emitting light with an emission spectrum centered on a predetermined central wavelength, comprising: an N-doped planar substrate (101); a laser section (110) comprising a front facet (111), an active layer (104) substantially parallel to the N-doped planar substrate, a first grating layer (102) arranged between the active layer (104) and the N-doped planar substrate, and a first Bragg grating (115) arranged in said first grating layer; a mirror section (120) optically coupled to said laser section and comprising said active layer, a second grating layer (132) coplanar with the first grating layer, and a second Bragg grating (125) arranged in the second grating layer and configured to reflect light towards said front facet. The first Bragg grating and the second Bragg grating are uniform Bragg gratings having the same pitch and the second Bragg grating has a reflectivity spectrum comprising said central wavelength of the emission spectrum.

## Description

### TECHNICAL FIELD OF THE INVENTION

The present description relates to distributed feedback lasers and photonic integrated circuits incorporating such lasers. Further, the present description relates to methods for fabricating such lasers.

### BACKGROUND OF THE INVENTION

Semiconductor devices configured to emit light are used in many technical fields such as optical sensing and optical communications. Distributed feedback (DFB) lasers are a particular type of semiconductor devices with a laser section comprising an active layer configured to emit light and a Bragg grating configured to select a central wavelength of the emitted light. The active layer is undoped and is arranged between P-doped layers and N-doped layers. The Bragg grating is arranged in a planar layer that is parallel to said active layer. Further, in such devices, the laser section is arranged between a front facet and a rear facet, the light being emitted out of the device through the front facet. Several designs of DFB lasers are known.

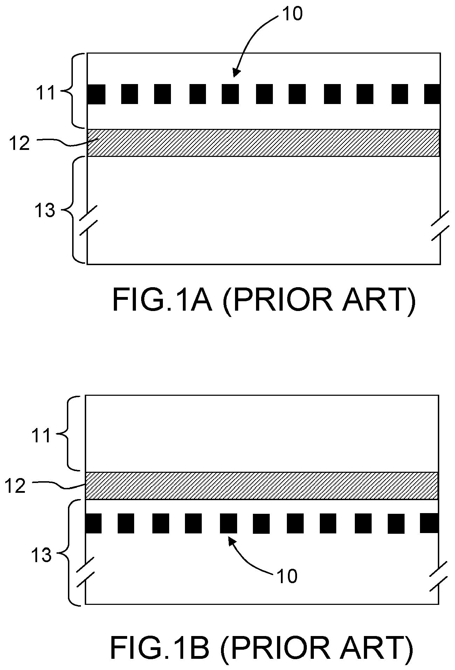

FIG. 1A represents a commonly used design of a DFB laser, hereafter referred to as "P-side" design. Such P-side design comprises an N-doped layer 13 arranged on a substrate side, a P-doped layer 11, a Bragg grating 10 that is arranged in said P-doped layer 11, and an undoped active layer 12 arranged between the N-doped layer 13 and the Bragg grating 10.

Alternatively, FIG. 1B represents an "N-side" design of a DFB laser (see, for example, [REF1], [REF 2] and [REF 3]). Such N-side design comprises an N-doped layer 13 arranged on a substrate side, a Bragg grating 10 that is arranged in said N-doped layer 13, a P-doped layer 11 and an undoped active layer 12 arranged between the Bragg grating 12 and the P-doped layer 11.

For most applications, a single-mode operation of the laser is generally preferred, *i.e.* when the emitted light has a bandwidth predominantly centered at a single wavelength. However, in a DFB laser, the presence of the Bragg grating in the laser section generally favors emission of light at two different wavelengths (dual-mode operation) separated by a spectral range referred to as the stopband of the laser.

The stop-band depends on the product of the length (L) of the laser section and the coupling coefficient (κ) of the laser section, wherein the coupling coefficient is also referred to as the coupling strength, defined as the "reflectivity per unit length" of the DFB laser and expressed in cm⁻¹.

In order to avoid dual-mode operation, an asymmetry is generally introduced in the DFB laser by adding, on the one hand, a mirror section consisting of a highly reflective (HR) coating at the rear facet and, on the other hand, an anti-reflection (AR) coating at the front facet. With said arrangement, referred to as HR/AR DFB lasers, one of the two modes in operation is favored over the other mode. Further, the optical power of the light emitted at the front facet is substantially doubled compared to a DFB laser without coatings, as almost no light is emitted through the rear facet.

However, it is generally not possible to control the exact position of the rear facet with respect to the Bragg grating, mainly due to fabrication constraints. As a result, upon back-and-forth propagation in the laser section and reflection on the HR coating, light generated in the active layer acquires a phase shift that cannot be predicted, which is also referred to as a "random phase condition". Such random phase condition leads to variable performances between distinct DFB lasers, such as variations of the output power and variations of the wavelength of the emitted light within the stop-band. In particular, the wavelength of the emitted light may not be controlled better than within the stopband. Further, the single-mode yield, or probability of the DFB laser to emit light in a single-mode, is reduced to typically 80-90%. This imposes DFB laser testing and selection for applications such as wavelength division multiplexing (WDM) wherein specific transmission channels are used.

To address such limitations, it is known to make DFB lasers with a laser section comprising a quarter-wave (λ/4) phase shift region in the middle of the Bragg grating and anti-reflection coatings on both the rear facet and the front facet, see for example [REF 4]. Such λ/4 phase shift region is configured to confer to light propagating in the laser section a phase shift equal to half of the period of the Bragg grating. Therefore, the resulting DFB laser, referred to as λ/4 phase shift DFB laser, emits light with a central wavelength that is naturally in the center of the stop-band. Therefore, such solution provides 100% single-mode yield and accurate control of the emitted wavelength.

Such λ/4 phase shift DFB lasers are compatible with N-side designs and P-side designs, but they emit light both at the rear facet and the front facet, causing a 50% reduction of emitted power from one facet compared to HR/AR DFB lasers.

Alternatively, as disclosed in [REF5], it is known to make DFB lasers with a mirror section arranged on a side of the laser section, such mirror section comprising a distributed Bragg reflector (DBR) with a second Bragg grating. The second Bragg grating is arranged in a planar layer that is parallel to the active layer and coplanar with the planar layer of the first Bragg grating of the laser section.

In such arrangement, during the fabrication of the DFB laser, it is possible to etch the first Bragg grating in the laser section and the second Bragg grating in the mirror section with the same etching mask. Therefore, the spacing between the first grating and the second grating is precisely defined by said etching mask. Thus, it is possible to accurately control the phase shift acquired by light upon propagation from the first Bragg grating in the laser section to the second Bragg grating in the mirror section and hereby achieve both a high single-mode yield and an accurate control of the wavelength of the emitted light.

However, the arrangement of [REF 5] is only compatible with DFB lasers with a P-side design and not with DFB lasers with an N-side design.

There is thus a need for alternative designs of distributed feedback lasers solving the problem of random phase condition and compatible with the N-side design.

### SUMMARY

In what follows, the term "comprise" is synonym of (means the same as) "include" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a single-mode distributed feedback (DFB) laser for emitting light with an emission spectrum centered on a predetermined central wavelength, the single-mode DFB laser comprising:
an N-doped planar substrate;
a laser section comprising:
   a front facet;
   an ensemble of layers configured to produce, with said N-doped planar substrate, a PIN junction, said ensemble of layers comprising: an active layer substantially parallel to the N-doped planar substrate and configured to emit light through said front facet, a first grating layer comprising N-doped material, arranged between the active layer and the N-doped planar substrate and in contact with an upper surface of said N-doped planar substrate, a spacer layer comprising N-doped material and arranged between the first grating layer and the active layer and a top layer comprising P-doped material; and
   a first Bragg grating arranged in said first grating layer;
a mirror section optically coupled to said laser section, and comprising: said active layer, a second grating layer and a second Bragg grating arranged in said second grating layer and configured to reflect light towards said front facet; wherein
the second grating layer is coplanar with the first grating layer;
the first Bragg grating and the second Bragg grating are uniform Bragg gratings and have the same pitch;
the second Bragg grating has a reflectivity spectrum comprising said central wavelength of said emission spectrum.

In the present description, two planar layers are said to be coplanar when an upper surface of the first of the two planar layers is at a predetermined distance from an upper surface of the second of the two planar layers that is inferior to a maximum distance, wherein said maximum distance is equal or inferior to about 50 nanometers, for example equal or inferior to about 20 nanometers. Conversely, two planar layers are not coplanar when said predetermined distance is superior to said maximum distance.

In the present description, a uniform Bragg grating is a Bragg grating comprising a material having a uniform periodic variation of the optical refractive index. For example, a uniform Bragg grating comprises alternating high refractive index regions and low refractive index regions and a constant distance (pitch) between said alternating high refractive index regions and low refractive index regions. Therefore, a uniform Bragg grating does not comprise several Bragg gratings with different pitches or a Bragg grating whose arrangement of alternating high refractive index regions and low refractive index regions generates a phase shift.

In the present description, a central wavelength of an emission spectrum is understood as a wavelength of a cavity mode of the DFB laser for which an emitted output power is maximum, e.g., with a side mode suppression ratio greater than about 40 dB compared to the other cavity modes.

In the present description, a single-mode DFB laser is a DFB laser emitting light with an emission spectrum predominantly centered at a single central wavelength. Therefore, such single-mode DFB laser is different from a multimode DFB laser emitting light with an emission spectrum centered at several wavelengths.

In the single-mode DFB laser according to the first aspect, the first and second Bragg gratings are arranged in N-doped layers, therefore such single-mode DFB laser is compatible with N-side designs. Further, the first Bragg grating and the second Bragg grating can be defined in a single step with a single etching mask thereby providing a predictable phase shift of the light propagating from the laser section to the mirror section, thus solving the problem of random phase condition. Therefore, such single-mode DFB laser has predictable performances, for example in terms of wavelength of the emitted light and power of the emitted light.

Further, in DFB lasers, the light propagation loss is predominantly due to Intervalence Band Absorption (IVA) in P-doped materials. In the single-mode DFB laser according to the first aspect, the first Bragg grating and the second Bragg grating comprise N-doped material. Therefore, the high refractive index regions of the first Bragg grating and the second Bragg grating pull the optical mode propagating inside the DFB laser towards the N-doped material and away from the P-doped material. Consequently, light propagates mainly in active material and N-doped material so that it undergoes very low attenuation. In particular light propagation loss within the single-mode DFB laser according to the present description is lower compared to standard designs of the prior art wherein light propagates mainly in active material and P-doped material.

Such an N-side design is particularly advantageous to obtain a single-mode DFB laser with reproducible performances. In particular, the wavelength of the emitted light of a DFB laser according to the first aspect can be precisely determined during the fabrication process which is particularly advantageous for applications that require a precise wavelength of the emitted light such as in telecommunication systems. Further, the DFB laser still provides a high output power, for example an output power higher than λ/4 DFB lasers of the prior art.

According to one or further embodiments, the N-doped planar substrate may comprise an upper region comprising N-doped material and a lower region, generally thicker, comprising semi-insulating material such as semi-insulating InP. The N-doped planar substrate may further comprise additional layers known in the art, such as a stop-etch layer, a sacrificial layer, or a higher index layer acting as an attractive layer.

According to one or further embodiments, the single-mode DFB laser comprises a spacing between the first Bragg grating of the laser section and the second Bragg grating of the mirror section, wherein such spacing is configured to induce a predetermined phase shift to the light propagating from the first Bragg grating to the second Bragg grating.

Such a predetermined phase shift can be advantageously predetermined to adapt parameters of the laser to different applications. Such parameters are, for example, the wavelength of the light emitted by the DFB laser, the single-mode operation of the DFB laser, the output power of the DFB laser, and the linewidth of the DFB laser. It is therefore possible to design the DFB laser with a phase shift that reliably optimizes such parameters.

According to one or further embodiments, the second grating layer is thicker, e.g. 20% or more than the first grating layer, and/or has a higher optical refractive index, e.g. 2% higher or more, than the first grating layer.

Such a configuration increases the coupling strength of the mirror section. Therefore, the mirror section of the DFB laser can be kept shorter than in DFB lasers of the prior art.

According to one or further embodiments, the mirror section further comprises a rear facet. The ensemble of layers of the mirror section is configured to produce, with said N-doped planar substrate, a PIN junction. Said ensemble of layers may at list comprise: the active layer, the second grating layer, the spacer layer and the top layer.

According to one or further embodiments, such DFB laser is configured to be a directly modulated laser.

According to a second aspect, the present description relates to a photonic integrated circuit comprising:
at least a first single-mode DFB laser according to the first aspect; and
at least a first additional section configured to receive light emitted by the single-mode DFB laser.

According to one or further embodiments, said at least first additional section is a modulation section configured to modulate the phase and/or amplitude of the light emitted by said at least first single-mode DFB laser.

According to one or further embodiments, said at least first additional section is a guiding section configured to guide the light emitted by said at least first single-mode DFB laser.

According to a third aspect, the present description relates to an integrated laser array comprising at least two single-mode DFB lasers according to the first aspect configured to emit light having emission spectra centered at two respective predetermined central wavelengths.

In such an integrated laser array, the central wavelength of the light emitted by each single-mode DFB laser can be precisely controlled. This is particularly advantageous in applications such as dense wavelength division multiplexing (DWDM), which requires lasers emitting light in predetermined wavelength channels with predefined accurate spacings, generally 100 GHz or 50 GHz, i.e., 0.8 nm and 0.4 nm.

To be implemented in a system, it is generally required that an integrated laser array comprise only single-mode lasers. That is why arrays are generally individually tested before implementation to ensure that they are reliable.

A single-mode yield of a plurality of arrays of lasers is defined as the proportion of arrays wherein all the lasers are emitting single-mode light. Therefore, the probability that a laser emits single-mode light affects drastically the single-mode yield of arrays of lasers, in particular for arrays comprising a large number of lasers, for example more than 4 lasers.

For example, laser arrays comprising ten AR/HR DFB lasers with typical 80% single-mode probability achieve a single-mode yield down to 10% (0.8¹⁰), which is incompatible with an industrial implementation. That is why arrays with a large number of DFB lasers is difficult to implement and is usually based on arrays using λ/4 lasers that have limited output power.

Advantageously, in the integrated laser array according to the third aspect, the lasers of the array have a higher single-mode probability and better control of the wavelength than DFB laser of the prior art without reducing the power by a factor of two as in λ/4 lasers. Therefore, integrated laser arrays according to the third aspect have a higher single-mode yield than integrated lasers arrays of the prior art and are compatible with large-scale industrial implementation while keeping a high output power.

A method for fabricating a single-mode DFB laser, comprising:
providing an N-doped planar substrate, a first grating layer and a spacer layer, wherein said first grating layer comprises N-doped material and is arranged on top of the N-doped planar substrate, and wherein said spacer layer is arranged on said first grating layer;
covering with a mask a first section of an ensemble of layers comprising said N-doped planar substrate, said first grating layer and said spacer layer, wherein said first section is intended to produce a laser section;
removing at least the spacer layer and the first grating layer in a second section of said ensemble of layers thereby forming a recess, wherein said second section is intended to produce a mirror section;
providing, into said recess of the second section, an ensemble of semiconductor layers comprising a second grating layer so that the second grating layer is coplanar with the first grating layer;
providing, in a single step, a grating mask covering at least partially the first section and at least partially the second section; such grating mask being configured to write a first Bragg grating in the first section and a second Bragg grating in the second section;
producing, using said grating mask, the first Bragg grating in the first section by etching at least a part of the first grating layer, and the second Bragg grating in the second section by etching at least a part of the second grating layer; and
performing, on top of said etched first grating layer and said etched second grating layer, a regrowth of N-doped material, active material and P-doped material in the first section and in the second section in order to produce a PIN junction extending in both the first section and second section.

With the method according to the third aspect, the first Bragg grating and the second Bragg grating can be defined in a single step using a single grating mask. Therefore, it is possible to precisely control the spacing between the first Bragg grating and the second Bragg grating in order to choose a phase shift acquired by light upon propagation between said first Bragg grating and said second Bragg grating.

Further, the phase shift can be controlled in order to control the photons distribution along the laser section and mirror section and homogenize power distribution by reducing photon concentration in the mirror section. In particular, this allows for a precise control of the wavelength of the emitted light, a reduction of spatial hole burning effect and an increase in the power emitted at the front facet which is beneficial for low linewidth and/or high-power lasers.

### BRIEF DESCRIPTION OF DRAWINGS

Other advantages and features of the invention will become apparent on reading the description, illustrated by the following figures which represent:
- FIG. 1A, already described, represents a sectional view of a P-side design of a single-mode DFB laser, according to the prior art;
- FIG. 1B, already described, represents a sectional view of an N-side design of a single-mode DFB laser, according to the prior art;
- FIG. 2A represents a sectional view along the direction of light propagation, of a single-mode DFB laser, according to embodiments of the present description;
- FIG. 2B represents a sectional view along the direction of light propagation, of a photonic integrated circuit comprising a single-mode DFB laser according to embodiments of the present description;
- FIGS. 3A-3B represent steps of a method for fabricating a single-mode DFB laser, according to embodiments of the present description;
- FIGS. 4A-4B represent further steps of a method for fabricating a single-mode DFB laser, according to embodiments of the present description;
- FIG. 5 represents a cross-section of a simulated mode propagating in a single-mode DFB laser with an N-side design according to the present description, compared to a single-mode DFB laser with a P-side design according to the prior art;
- FIG. 6 represents the output power of a DFB laser with an N-side design according to the present description, compared to a single-mode DFB laser with a P-side design according to the present description.

### DETAILED DESCRIPTION

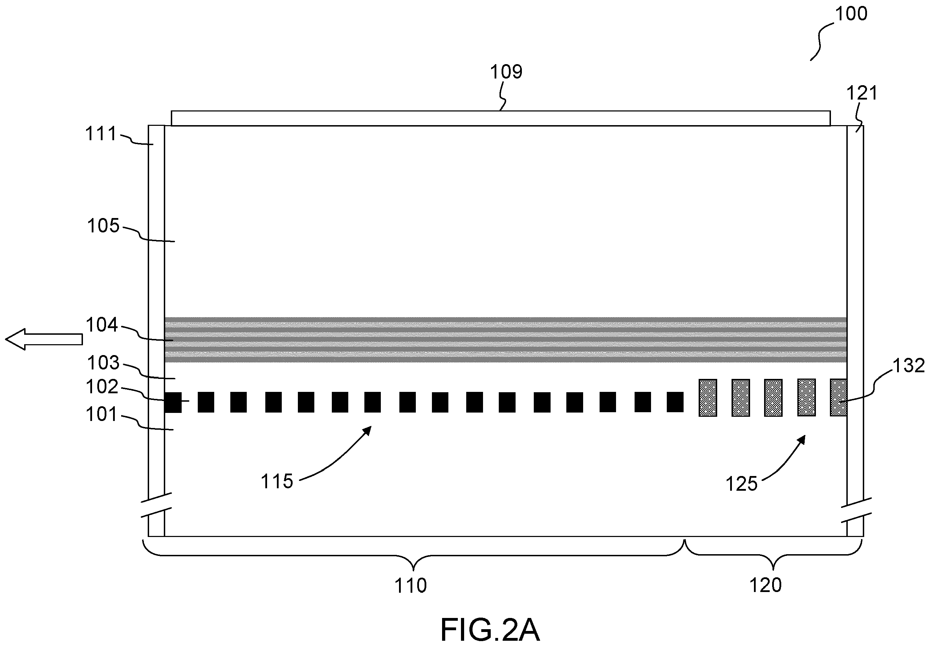

FIG. 2A represents a sectional view of an example of a single-mode DFB laser 100 according to the present disclosure. The sectional view is made in a plane comprising the direction of propagation of light in the single-mode DFB laser and perpendicular to the plane of the substrate. The single-mode DFB laser comprises a laser section 110 configured to emit light and a mirror section 120 configured to reflect light emitted by the laser section 110.

The laser section 110 comprises an N-doped planar substrate 101, a first grating layer 102 in contact with an upper surface of the N-doped planar substrate 101, a first Bragg grating 115 arranged in the first grating layer 102, for example etched through said first grating layer as it will be described below. The laser section 110 further comprises an active layer 104 on top of the first Bragg grating 115. A top layer 105 is arranged on top of the active layer 104. In the example illustrated in FIG. 2A, an optional contact layer 109 is arranged on top of the top layer 105. The active layer 104 and the first Bragg grating 115 are separated by a spacer layer 103 configured to control the distance between the active layer 104 and the first Bragg grating 115. Such ensemble of layers forms a PIN junction.

The first Bragg grating is a uniform grating, with a constant pitch.

In operation, the active layer 104 is configured to emit light at a predetermined single wavelength and guide said light towards the mirror section 120. The active layer 104 may comprise an ensemble of semiconductor layers, for example multi-quantum wells based on InGaAsP or InGaAlAs or other ternary or quaternary materials.

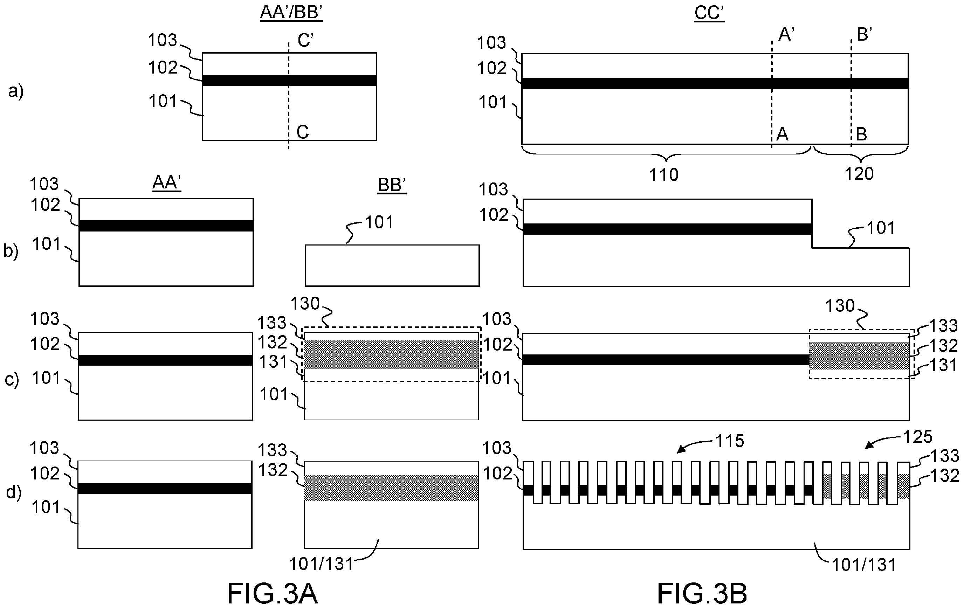

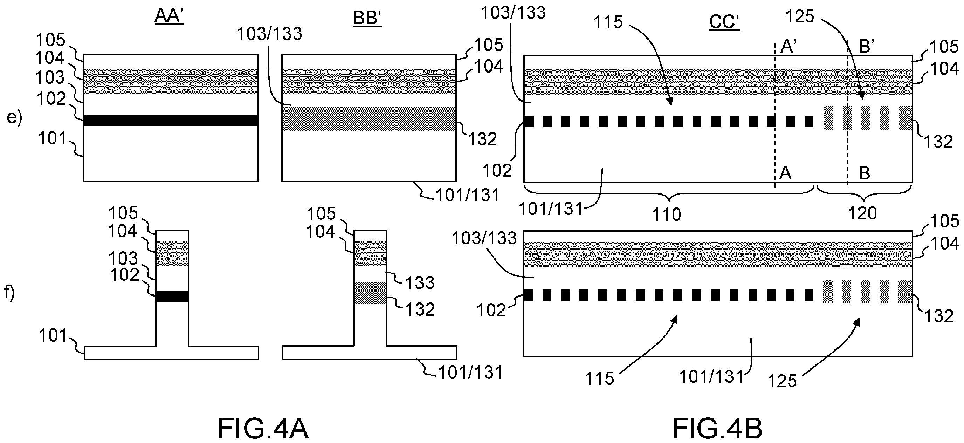

The N-doped planar substrate 101 comprises N-doped material, such as N-doped InP. The N-doped planar substrate is generally thicker than other layers, which is represented on FIG. 2A (and similarly on FIG. 3 and 4) by broken lines in the figures.

Although not represented, the N-doped planar substrate 101 may comprise an upper region comprising said N-doped material, for example N-doped InP, and a lower region, generally thicker, comprising semi-insulating material such as semi-insulating InP.

The spacer layer comprises N-doped material, for example the same material as the N-doped material of the substrate 101, for example N-doped InP.

The first grating layer 102 may comprise an N-doped quaternary material such as N-doped InGaAsP.

The top layer 105 comprises P-doped material, such as P-doped InP.

In some embodiments, the first Bragg grating 115 is etched through the first grating layer 102 and comprises alternating high-index regions made of the material of the first grating layer 102 and low-index regions made of the material of the spacer layer 103, wherein the high-index regions and the low-index regions are separated by a predetermined first grating pitch. The first grating pitch depends on the desired wavelength of the emitted light, and may for example be comprised between about 190 nanometers and about 250 nanometers for telecom wavelengths, wherein telecom wavelengths are wavelengths comprised between about 1270 nanometers and about 1580 nanometers.

The laser section 110 may be configured to emit light when a voltage or current is applied between the top layer 105 and the N-doped planar substrate 101 or between materials electrically connected to the top layer 105 and the N-doped planar substrate 101.

The laser section 110 comprises a front facet 111 arranged perpendicularly to the planar surface of the layers 101, 102, 103, 104, 105. The front facet 111 is configured to transmit light out from the laser section 110 to the outside of the DFB laser 100.

According to embodiments, the front facet 111 comprises an anti-reflection coating configured to facilitate transmission of light at a predetermined wavelength, for example a telecom wavelength. In particular, the front facet 111 may comprise an anti-reflection coating so that reflection coefficient of light at a predetermined wavelength on the front facet 111 is inferior or equal to about 5%. According to embodiments, the anti-reflection coating comprises a couple of layers with one layer of Ti02 and one layer of Si02, or a plurality of such couple of layers.

The mirror section 120 comprises the N-doped planar substrate 101, a second grating layer 132 that is planar and coplanar with the first grating layer 102, a second Bragg grating 125 etched through the second grating layer, the active layer 104 arranged on top of the second Bragg grating 125, the top layer 105 and a rear facet 121. The active layer 104 and the second Bragg grating 125 are separated by the spacer layer 103. As for the laser section, the ensemble of layers of the mirror section produces, with the N-doped planar substrate, a PIN junction.

The second Bragg grating is a uniform grating, with a constant pitch equal to the pitch of the first Bragg grating.

Light generated in the active layer 104 of the laser section 110 propagates partially towards the mirror section 120 and is reflected towards the laser section 110 upon propagation within the active layer 104 in the mirror section 120 due to the presence of the second Bragg grating 125.

The distance between the first Bragg grating 115 and the second Bragg grating 125 may be predetermined so that light propagating from the laser section 110 to the mirror section 120 acquires a predetermined phase shift at the interface between the two sections.

The rear facet 121 may comprise an anti-reflection coating configured to reduce the proportion of light that is reflected at the interface between the mirror section 120 and the rear facet 121. Therefore, possible reflections of light by the rear facet 121 are substantially avoided and do not disturb reflection of light by the second Bragg grating 125 within the mirror section 120 towards the laser section 110.

The second Bragg grating 125 comprises alternating high-index regions and low-index regions separated by a predetermined second grating pitch. The second grating pitch is generally comprised between about 190 nanometers and about 250 nanometers for telecom wavelengths.

In the DFB laser according to the present description, the first grating pitch and the second grating pitch are equal so that the reflectivity spectrum of the first Bragg grating 115 and the reflectivity spectrum of the second Bragg grating 125 are centered on substantially the same predetermined wavelength. The fact that the reflectivity spectrum of the two Bragg gratings 115, 125 are centered on the substantially the same wavelength ensures that the DFB laser is a single-mode laser, *i.e*., it emits light in a single mode.

As illustrated in FIG. 2A, the laser section 110 and the mirror section 120 may be covered at least partially by a contact layer 109 configured to provide ohmic contact to the top layer 105, for example in order to apply a voltage or current to the DFB laser so that it emits light. The contact layer 109 may comprise, for example, metallic materials such as Platinum (Pt), Titanium (Ti) or Gold (Au).

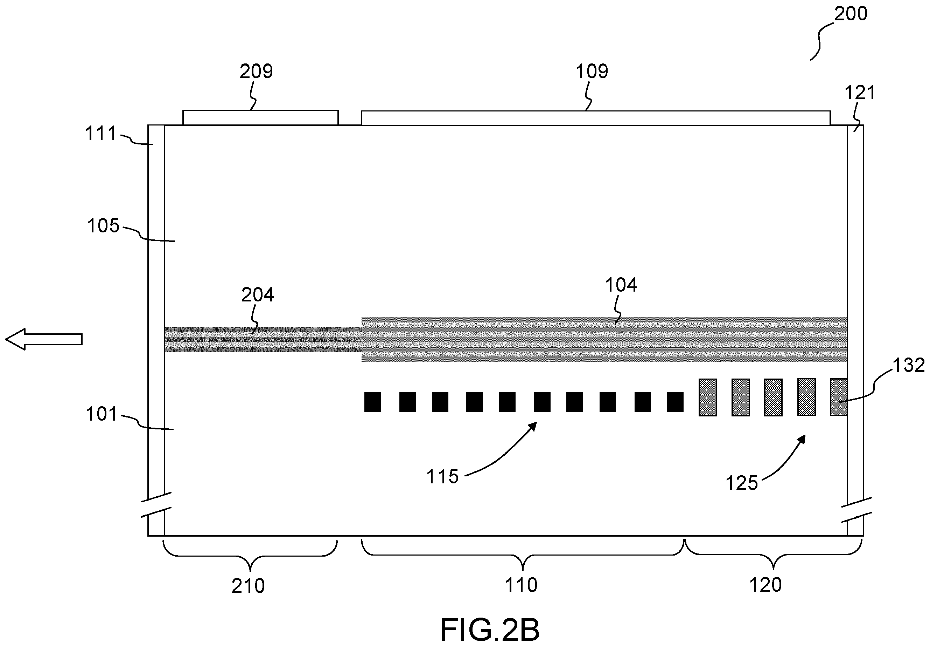

FIG. 2B represents an example of a photonic integrated circuit 200 comprising a single-mode DFB laser according to the present description, for example a DFB laser as described in FIG. 2A.

In addition to features of the DFB laser already described, the photonic circuit 200 further comprises at least a first additional section 210 configured to receive light emitted by the active layer 104 of the single-mode DFB laser. For example, said at least first additional section is a modulation section configured to modulate the phase and/or amplitude of the light emitted by the single-mode DFB laser, or a guiding section configured to guide the light emitted by the single-mode DFB laser.

The additional section 210 comprises an ensemble of layers comprising an active layer 204, coplanar with the active layer 104 of the DFB laser and may also comprise on top of said ensemble of layers, a contact layer 209. The active layer may comprise a bulk material or quantum wells or multi-quantum wells, as known in the art. The ensemble of layers of the section 210 may be arranged on the same substrate 101 as the substrate of the DFB laser. The ensemble of layers of the additional section 210 mays be configured to produce an electro-absorption modulator, a phase modulator, an optical amplifier, or any other optical function known in the art.

FIGS. 3A-3B and 4A - 4B represent steps of a method for fabricating a single-mode DFB laser, according to embodiments. In particular, FIGS. 3A-3B and 4A - 4B illustrate different steps (a), (b), (c), (d), € and (f) of a fabrication method of a DFB laser represented under several sectional views (AA', BB', CC').

Sectional view AA' illustrates the stacking of layers in the laser section 110. Sectional view B-B' illustrates the stacking of layers in the mirror section 120. Sectional view CC' illustrates the stacking of layers within the DFB laser along the direction of light propagation, *i.e*., throughout the laser section 110 and the mirror section 120, in a plane comprising the direction of propagation of light and perpendicular to the plane of the substrate.

In step (a), a first ensemble of semiconductor layers 101, 102, 103 is provided. Such first ensemble of layers comprises an N-doped planar substrate 101, a grating layer 102; and an N-doped spacer layer 103.

According to embodiments, the grating layer 102 may comprise, for example, InGaAsP material. The grating layer 102 may have a thickness comprised between about 20 nanometers and about 200 nanometers.

According to embodiments, the spacer layer 103 may comprise, for example, N-doped InP and may have a thickness comprised between about 70 nanometers and 200 nanometers.

In step (b), a mask (not represented in FIGS. 3A-3B) is deposited on a first section 110 of the ensemble of layers 101, 102, 103, the rest of the ensemble of layers defining a second section 120. Such mask is used to etch totally the spacer layer 103 and the grating layer 102 in the second section 120 in order to uncover the N-doped planar substrate 101. The first section 110 is intended to form a laser section configured to generate light, and the second section 120 is intended to form a mirror section configured to reflect the light generated by the first section 110 towards the first section 110. Therefore, in the present description, the first section 110 is referred to as the laser section 110 and the second section 120 is referred to as the mirror section 120.

Further, as illustrated in FIG. 3B, in step (b), the etch may be configured to further remove a predetermined thickness of the N-doped planar substrate 101 in order to ensure that all the thickness of the grating layer 102 is etched in the mirror section 120. This also makes it possible to perform, in a subsequent step, an epitaxial regrowth starting from the N-doped planar substrate 101 which acts as a buffer layer facilitating regrowth compared to a regrowth starting from a remaining thickness of grating layer 102.

In step (c), a second ensemble 130 of semiconductor layers comprising a second grating layer 132 is butt-jointed to the mirror section 120 so that said second grating layer 132 is arranged in a planar layer that is coplanar to the grating layer 102 of the laser section 110.

The thickness of the ensemble 130 is chosen so that, after integration, the upper surface of the ensemble 130 is flush with the upper surface of the spacer layer 103.

Although, in FIGS. 3A-3B, step (c) specifically illustrates an integration based on the butt-coupling technology, other techniques could alternatively be used, such as, selective area growth or intermixing. The skilled person will know how to adapt the steps of the method to the integration technique that is used.

As illustrated in FIGS. 3A-3B, the ensemble 130 of semiconductor layers may comprise an auxiliary substrate layer 131 and an auxiliary spacer layer 133. The auxiliary substrate layer 131 may comprise the same N-doped material as the N-doped material of the planar substrate 101. The auxiliary top layer 133 may comprise the same material as the spacer layer 103.

In step (d), a grating mask layer (not represented in FIGS. 3A-3B) is provided on both the first section 110 and the second section 120.

A grating mask is then provided by structuration of the grating mask layer in function of the desired parameters of the first and second Bragg grating (115, 125), for example by e-beam, holography or other techniques known from the skilled man. The structure of the first and the second Bragg gratings (115, 125) is therefore simultaneously designed with such grating mask.

Further, such first and second Bragg gratings (115, 125) are then produced by etching parts of the first section 110 and parts of the second section 120 using said grating mask, respectively. The grating mask is configured to produce, after the etching, a first Bragg grating 115 and a second Bragg grating 125 separated by a predetermined distance. For example, a distance comprised between about 0 nanometers and about 10 micrometers.

Such distance is defined with the grating mask so that, once the DFB laser is fabricated, the light propagating from the first section 110 to the second section 120 acquires a predetermined phase shift at the interface between the two sections (110, 120).

According to embodiments, the etching of the first Bragg grating 115 and the etching of second Bragg grating 125 may be performed in a single step. According to other embodiments, the etching of the first Bragg grating 115 and the etching of the second Bragg grating 125 may be performed in two different steps.

The first Bragg grating 115 is produced in the first section 110 by etching through the spacer layer 103 and the grating layer 102. Further, as illustrated in FIG. 3B, in step (d), a predetermined thickness of the planar layer 101 can also be etched in order to ensure that all the thickness of the grating layer 102 has been etched in the laser section 110 and to reduce the sensitivity of the coupling strength in the laser section 110 to the etching depth in the grating layer 102.

The second Bragg grating 125 is produced in the mirror section 120 by etching through the auxiliary spacer layer 133, the second grating layer 132, and through the auxiliary planar layer 131. Further, as in the example illustrated in FIG. 3B, in step (d), a part of the N-doped planar substrate 101 can also be etched to ensure that all the thickness of the second grating layer 132 has been etched in the mirror section 120 in order to reach the highest possible coupling strength and to reduce the sensitivity of the coupling strength of the mirror section 120 to the etching depth in the second grating layer 132.

FIGS. 4A-4B represent further steps of a method for fabricating a single-mode DFB laser, according to embodiments. In particular, FIGS. 4A-4B illustrate different steps (e), (f) of a fabrication method of a DFB laser under the sectional views AA', BB', CC'.

In step (e), trenches in the laser section 110 and in the mirror section 120 that were caused by the etch of step (d) are filled up using an epitaxial regrowth with N-doped material, for example the same material as the material comprised in an upper region of the N-doped planar substrate 101. Further, such regrowth aims at planarizing the upper surface of the laser section 110 and the mirror section 120. This regrowth may comprise, for example, growing N-doped material from the bottom of the trenches in order to reform a spacer layer 103 on top of the layer comprising the gratings (115, 125). In particular, such reformed spacer layer 103 may have a thickness comprised between about 70 nanometers and about 200 nanometers. The N-doped material may be, for example, N-doped InP.

Further, in step (e), an active layer 104 and a top layer 105 are grown, for example by epitaxial regrowth, on top of the reformed spacer layer 103.

The active layer 104 comprises undoped active material configured to emit light, for example quantum wells or multi-quantum wells.

The top layer 105 comprises a P-doped material, for example P-doped InP.

Therefore, the undoped active layer is sandwiched between the N-doped layers (the substrate layer, the Bragg gratings, and the spacer layer) and the P-doped top layer thus forming a PIN junction.

According to embodiments, not illustrated in Fig. 4A-4B, the top layer 105 may optionally be covered, at least partially, by a contact layer.

In step (f), a final etch is performed to produce the optical waveguide from the stack of layers comprising the active layer 104, the grating layers (102, 132) and the top layer 105.

In the example illustrated in FIGS. 4A-4B, after step (f), the obtained device is generally buried in semi-insulating InP or P-doped InP using epitaxial regrowth.

Alternatively, although not illustrated, the epitaxial regrowth of step (e) could comprise a thicker P-doped material, for example up to about 2 micrometers or up to about 3 micrometers, in which case the final etch of step (f) is performed only through the P-doped material (i.e. top layer 105) in order to produce a shallow ridge waveguide, or is performed through the P-doped material and through the active layer 102 in order to produce a deep ridge waveguide.

After step (f), additional steps known from to the skilled person may be performed in order to obtain a finalized DFB laser.

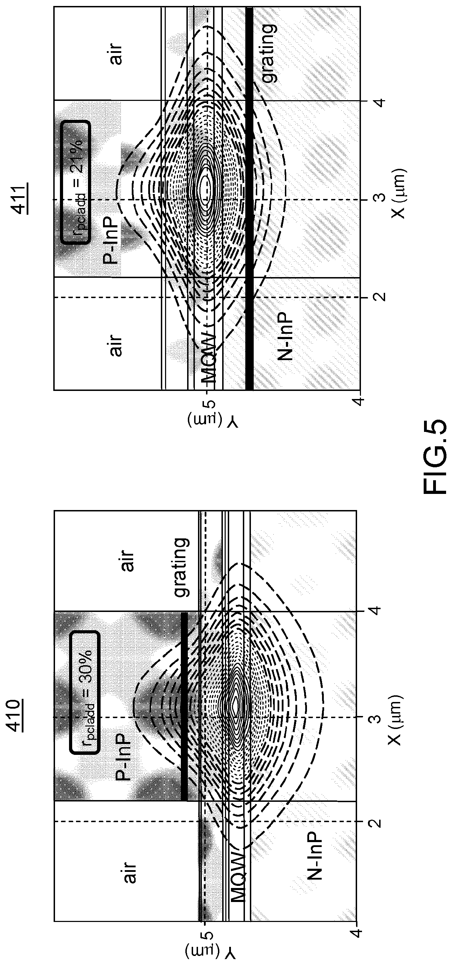

FIG. 5 represents a cross-section (along the AA'/BB' axis) of a simulated optical mode propagating in a DFB laser with a P-side design according to the prior art, i.e. with Bragg gratings comprised in P-doped material, see diagram 410, and in a DFB laser with an N-side design according to the present description, i.e. with Bragg gratings comprised in N-doped material, see diagram 411. FIG. 5 shows, in particular, that the gratings tend to pull the optical mode towards their side.

In particular, when the Bragg gratings are on the side of the N-doped material (i.e. as illustrated in diagram 411), the optical mode is pulled away from the P-doped material and, therefore, undergoes a lower attenuation than in the case wherein the Bragg gratings are on the side of the P-doped material.

The r_{pcladd} coefficient is the optical confinement ratio of the optical mode propagating in the P-doped layers (cladding layers) of the DFB laser. FIG. 5 shows that the optical confinement in the P-doped layers is reduced from 30% to 21%, which results in a reduction of the optical losses when light propagates in the DFB laser with the N-side design compared to the DFB laser with the P-side design.

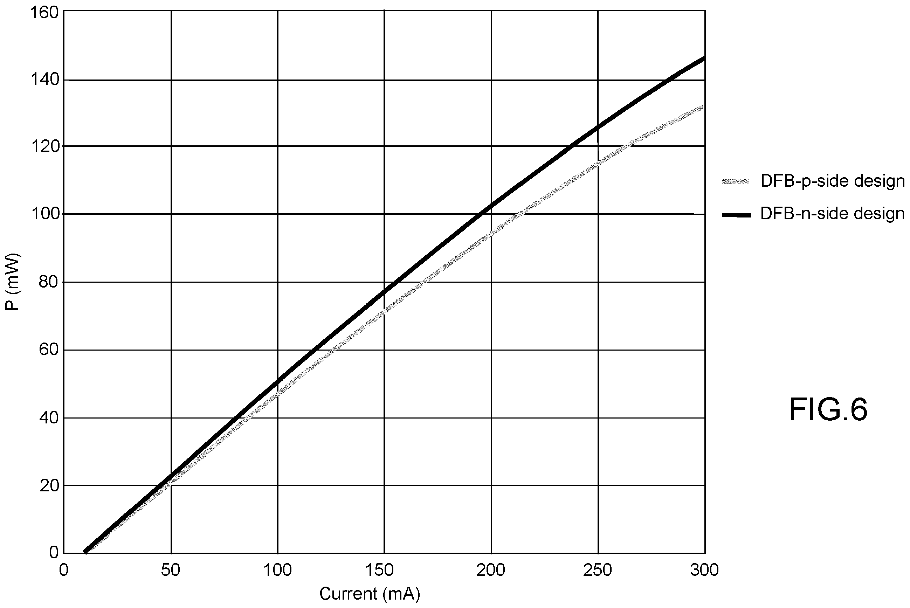

FIG. 6 represents the simulated output power as a function of the current of a DFB laser with a P-side design according to the prior art, comprising a Bragg grating comprised in P-doped material (light curve), and of a DFB laser with a N-side design according to the present description, with Bragg gratings comprised in N-doped material (dark curve). FIG. 6 shows, in particular, that the output power emitted by a DFB laser is superior when the Bragg gratings are on the side of the N-doped material (as is the case in the single-mode DFB laser according to the present description). Such superior output power is a consequence of the physical effect explained above when discussing FIG. 5.

While the invention has been described with respect to a limited number of embodiments, those skilled in the art, having benefit of this disclosure, will appreciate that other embodiments can be devised which do not depart from the spirit of the invention as disclosed herein. Accordingly, the scope of the invention should be limited only by the attached claims.

### REFERENCES

[REF 1] Nakamura, T., Okuda, T., Kobayashi, R., Muroya, Y., Tsuruoka, K., Ohsawa, Y., Tsukuda, T. and Ishikawa, S., 2005. 1.3-µm AlGaInAs strain compensated MQW-buried-heterostructure lasers for uncooled 10-gb/s operation. IEEE Journal of selected topics in quantum electronics, 11(1), pp.141-148.
[REF 2] Matsuda, M., Uetake, A., Simoyama, T., Okumura, S., Takabayashi, K., Ekawa, M. and Yamamoto, T., 2015. 1.3-µm-wavelength AlGaInAs multiple-quantum-well semi-insulating buried-heterostructure distributed-reflector laser arrays on semi-insulating InP substrate. IEEE Journal of Selected Topics in Quantum Electronics, 21(6), pp.241-247.
[REF 3] Otsubo, K., Matsuda, M., Takada, K., Okumura, S., Ekawa, M., Tanaka, H., Ide, S., Mori, K. and Yamamoto, T., 2009. 1.3-µm AlGaInAs Multiple-Quantum-Well Semi-insulating Buried-Heterostructure Distributed-Feedback Lasers for High-Speed Direct Modulation. IEEE Journal of Selected Topics in Quantum Electronics, 15(3), pp.687-693.
[REF 4] DEBREGEAS, H., FERRARI, C., PAPAZIAN, A. R., et al. High-performance 100Gb/s DWDM transmitter through fully passive assembly of a single-chip array of directly modulated lasers with a SiO2 AWG. In : 2014 International Semiconductor Laser Conference. IEEE, 2014. p. 56-57.
[REF 5] SHIM, J.-I., KOMORI, K., ARAI, S., et al. Lasing characteristics of 1.5 mu m GaInAsP-InP SCH-BIG-DR lasers. IEEE journal of quantum electronics, 1991, vol. 27, no 6, p. 1736-1745).

## Claims

1. A single-mode distributed feedback (DFB) laser (100) for emitting light with an emission spectrum centered on a predetermined central wavelength, the single-mode DFB laser comprising:
an N-doped planar substrate (101);
a laser section (110) comprising:
a front facet (111);
an ensemble of layers configured to produce, with said N-doped planar substrate, a PIN junction, said ensemble of layers comprising: an active layer (104) substantially parallel to the N-doped planar substrate (101) and configured to emit light through said front facet (111), a first grating layer (102) comprising N-doped material, arranged between the active layer (104) and the N-doped planar substrate (101) and in contact with an upper surface of said N-doped planar substrate (101), a spacer layer (103) comprising N-doped material and arranged between the first grating layer (102) and the active layer (104) and a top layer (105) comprising P-doped material; and
a first Bragg grating (115) arranged in said first grating layer (102);
a mirror section (120) optically coupled to said laser section (110), and comprising: said active layer (104), a second grating layer (132) and a second Bragg grating (125) arranged in said second grating layer (132) and configured to reflect light towards said front facet (111); wherein
the second grating layer (132) is coplanar with the first grating layer (102);
the first Bragg grating (115) and the second Bragg grating (125) are uniform Bragg gratings and have the same pitch;
the second Bragg grating (125) has a reflectivity spectrum comprising said central wavelength of said emission spectrum.

2. The single-mode DFB laser according to claim 1, further comprising a spacing between the first Bragg grating (115) of the laser section (110) and the second Bragg grating (125) of the mirror section (120), wherein said spacing is configured to induce a predetermined phase shift to the light propagating from the first Bragg grating (115) to the second Bragg grating (125).

3. The single-mode DFB laser according to any one of the preceding claims, wherein the second grating layer (132) is thicker and/or has a higher optical index than the first grating layer (102).

4. The single-mode DFB laser according to any one of the preceding claims, wherein such DFB laser is configured to be a directly modulated laser.

5. A photonic integrated circuit (200) comprising:
- at least a first single-mode DFB laser (100) according to any one of the preceding claims; and
- at least a first additional section (210) configured to receive light emitted by the single-mode DFB laser (100).

6. The photonic integrated circuit according to claim 5, wherein said at least first additional section is a modulation section configured to modulate the phase and/or amplitude of the light emitted by said at least first single-mode DFB laser.

7. The photonic integrated circuit according to claim 5, wherein said at least first additional section is a guiding section configured to guide the light emitted by said at least first single-mode DFB laser.

8. An integrated laser array comprising at least two single-mode DFB lasers according to any one of claims 1 to 4, configured to emit light having emission spectra centered at two respective predetermined central wavelengths.

9. A method for fabricating a single-mode DFB laser, comprising:
providing a first ensemble of layers comprising an N-doped planar substrate (101), a first grating layer (102) and a spacer layer (103), wherein said first grating layer (102) comprises N-doped material and is arranged in contact with an upper surface of the N-doped planar substrate (101), and wherein said spacer layer (103) is arranged on top of said first grating layer (102);
covering with a mask a first section (110) of said first ensemble of layers, wherein said first section is intended to produce a laser section;
removing at least the spacer layer (103) and the first grating layer (102) in a second section (120) of said first ensemble of layers, thereby forming a recess, wherein said second section (120) is intended to produce a mirror section;
providing, into said recess of the second section (120), a second ensemble (130) of layers comprising a second grating layer (132) so that the second grating layer (132) is coplanar with the first grating layer (102);
providing, in a single step, a grating mask covering at least partially the first section (110) and at least partially the second section (120), such grating mask being configured to define a first Bragg grating (115) in the first section (110) and a second Bragg grating (125) in the second section (120);
producing, using said grating mask, the first Bragg grating (115) in the first section (110) by etching at least a part of the first grating layer (102), and the second Bragg grating (125) in the second section (120) by etching at least a part of the second grating layer (132); and
performing, on top of said etched first grating layer (102) and said etched second grating layer (132), a regrowth of N-doped material, active material (104) and P-doped material (105) in the first section (110) and in the second section (120) in order to produce a PIN junction extending in both the first section (110) and second section (120).
